# EUROPEAN PATENT APPLICATION

(11) **EP 1 848 042 A1**
(43) Date of publication of application: **24.10.2007**
(21) Application number: 06008292.2
(22) Date of filing: 21.04.2006
(51) Int. Cl.: H01L 33/00

(54) **LED package with submount**

(71) Applicant: LEXEDIS Lighting GmbH, 8380 Jennersdorf (AT)
(72) Inventor: Kawaguchi, Hiroaki, A-8280 Fürstenfeld (AT); Shepherd, Nick, Dr., A-8280 Fürstenfeld (AT)
(74) Representative: Rupp, Christian

(57) **Abstract**

A LED package comprises:
- a LED chip (1) having an optically active layer on a substrate,
- a submount, on a central membrane of which the LED chip (1) is mounted in close thermal contact to the material of the submount,
the thickness of the membrane being less than 100 µm, preferably less than 80µm and the thickness of a frame of the submount which is integrally formed with the cavity, is substantially larger than the thickness of the cavity.

## Description

The present invention relates to a LED package having a LED chip on a submount.

It is known to provide high brightness (HB) LEDs and mid-power LEDs in a so-called package, in which the LEDs are mounted on a supporting substrate.

The LED chip thereby is mounted on a dielectric material that has mechanical properties and relatively good thermal conductivity. The currently used materials for the substrate and the submount require minimum manufacturing thicknesses. For the face-up (FU) LED chip design the substrate of the LED chip can be bonded to the submount using an adhesive or solder.

The present development of flip chip (FC) technology is to minimise the thermal path to the package allowing improved thermal control of the light emitting semiconductor material. For FC application bonding techniques such as gold wire bonding can be used that only connected two materials at a low percentage of the LED electrode area. However, this mounting technique is expensive and offers limited mechanical support and limited thermal properties.

Now, there is the problem that high brightness (HB) LED chips are operated with increasing power. The light conversion efficiency of the LED chip is quite low, thus that the heat generated by the LED chip has to be removed to the ambient through package material. The majority of the costs incurred by packaged LEDs is still dominated by the material costs, which in addition to the LED can be relatively high compared to the overall manufacturing costs.

It is a problem that often the package material represents the weakest link for the heat transfer from the chip to the ambience. Note that thermally well conducting material such as metal mounts can not be used, as the electrical contact to the LED have to electrically isolated. Using dielectric materials with a very high thermal conductivity represents advantages, but involves high costs.

Therefore, it is the object of the present invention to provide for a LED packaging technique allowing improved thermal characteristics.

This object is achieved by means of the features of the independent claims. The dependent claims develop further the central idea of the present invention.

According to a first aspect of the present invention, a LED package (LED package) is proposed comprising a LED chip having an optically active layer on a substrate. The LED chip is fixed to a recessed membrane of a cavity of a submount in thermal contact to the material of the membrane of the cavity of the submount. The thickness of the cavity is preferably less than some 100 µm, preferably less than 80 µm. The thickness of a frame of the submount which is integrally formed with the membrane of the cavity and preferably surrounds the cavity, is made substantially larger than the thickness of the cavity.

Preferably, the LED substrate has a thickness of at least in the range of 100 µm or more.

The LED chip substrate can be made from sapphire, silicon or SiC.

The submount can be made from sapphire or silicon.

The walls of the cavity surrounding the membrane can be designed as serving as a reflector for light emitted from the LED chip.

The walls of the cavity can be coated with a reflecting material.

Preferably the thermal resistance of the membrane of the submount is less than 5 K/W.

The frame of the submount has a thickness of at least 300 µm, preferably more than 400 µm, which is substantially more than the thickness of the membrane.

The cavity can be obtainable by the use of a SOI (silicon-on-insulator) bonded wafer and MEMS etch process technology.

The cavity can be at least partially filled with a colour conversion material being in contact or spatially separated from the LED chip.

The membrane can be provided with at least a through hole filled with electrically conducting material and connected to one of the electrodes of the LED chip.

In case of using the flip chip technology, the membrane can be provided with two through holes respectively filled with electrically conducting material and connected to one of the electrodes of the LED chip.

A further aspect of the present invention relates to a manufacturing method for a LED package as defined above, wherein the manufacturing method comprises the steps of oxidising one silicon wafer, directly bonding this to a second silicon wafer to produce a bonded pair, thinning to the desired membrane thickness, selectively etching the cavity through the face of the first silicon wafer, and at the same time forming, integrally with the cavity, the frame of the submount.

A still further aspect of the present invention relates to a manufacturing method for a LED package. A submount is prepared having a membrane with a thickness of some 100 µm or less and a frame integrating formed with and essentially surrounding the membrane and having a thickness which is essentially larger than the thickness of the membrane. Thereby, during the preparation of the membrane, the membrane is always supported by the thicker frame. Finally, a LED chip is mounted on the membrane.

The step of mounting the LED chip can comprise the step of selecting LED chip having a substrate with a thickness such that the substrate of the LED chip, together with the frame of the submount, procure sufficient mechanical properties to the LED package.

Therefore, the invention proposes to select a matching combination of the materials and the thickness of the substrate of the LED chip and the material of the membrane, respectively.

The method can comprise the step of selecting the materials of the LED chip substrate and the submount, respectively, such that they have essentially comparable thermal characteristics.

The thermal resistance of the membrane material can be selected to be some 5 K/W or less.

The invention therefore proposes to use a LED chip on a supporting substrate and a thin membrane of a submount in the overall package in order to have the necessary mechanical and thermal properties.

Preferably silicon can be used as a material for the submount, as the thermal conductivity of silicon is relatively high and the native silicon oxide can be used as an electrical isolator.

Further on, in case the LED chip substrate is made from sapphire, it is of advantage that the CTE (coefficient of thermal expression) of sapphire and silicon essentially similar.

Further advantages, features and objects of the present invention will now become evident of the man skilled in the art with reference to the following detailed description of preferred embodiments taken in conjunction with the thickness of the enclosed drawings.
- Fig. 1: shows schematically a LED chip which can be used in connection with the present invention and which has a sapphire substrate,
- Fig. 2: shows schematically an example of a submount according to the present invention having a thin silicon membrane and a relatively thick, integrally formed supporting frame,
- Fig. 3: shows an example of a LED package having a FU (face up) mount,
- Fig. 4: shows an example of a FC (flip chip) LED chip mount, and
- Fig. 5: shows different possibilities of providing a colour conversion material above and/or surrounding the LED chip.

The development of high power (high output flux) LED has resulted in chip designs using thicker supporting substrates, wherein the optical emitting layer is different to the supporting substrate.

The invention proposes to use a LED chip with a relatively thick substrate e.g. made from sapphire. The substrate can have a thickness of more than 200 µm, preferably more than 300 µm, most preferred more than 400 µm.

Therefore, according to the invention, the relatively thick LED chip substrate can be used in order to contribute to the mechanical characteristics of the overall package, i.e. the combination of the LED chip and the submount.

The invention proposes to make advantage of the fact that such a supporting substrate is mechanically more robust than the optical emitting layer (e.g. GaN, GaAs).

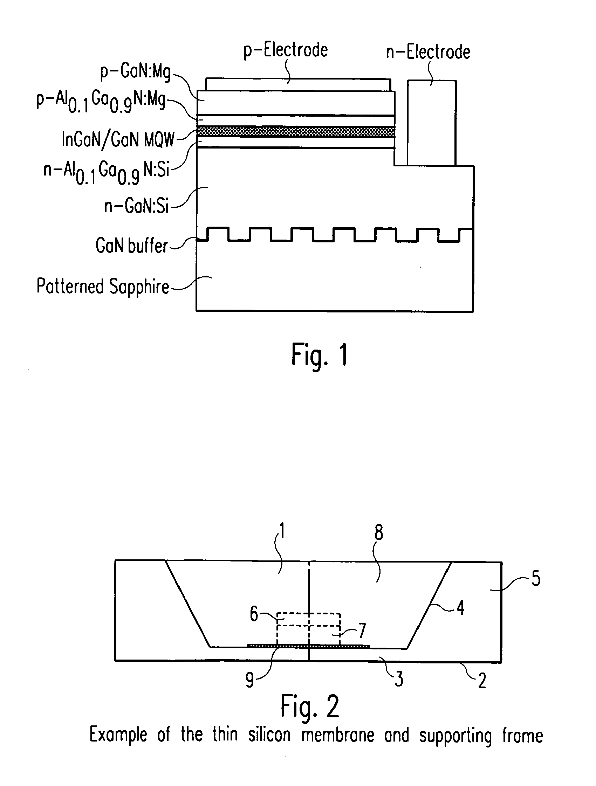

Fig. 1 shows an example of a LED chip which can be used in connection with the present invention.

Of importance is especially the relatively thick sapphire substrate, which can be patterned.

Now, the invention proposes to use a LED chip 1 having an optically active layer 6 on a substrate 7 in connection with a submount 2 as shown in Fig. 2.

This submount 2 has a cavity 8, the bottom of which is formed by a recessed and relatively thin membrane 3 surrounded by a supporting frame 5 which is relatively thick and thus solid in comparison to the thin membrane 3. The LED chip 1 can be mount to the membrane 3 for example by using an adhesive or by soldering 9.

According to the invention, the thickness of the membrane 3 is less than 150 µm, preferably less than 100 µm and most preferred in the range of 40 µm to 70 µm.

The membrane 3 is made integrally with the supporting frame 5 and thus from the same material as the supporting frame 5.

The walls 4 of the cavity 8 can be inclined e.g. in an angle of between 40 and 60 degrees. The walls 4 of the cavity 8 can serve as a reflector, and, to this regard, can be coated with a reflecting material.

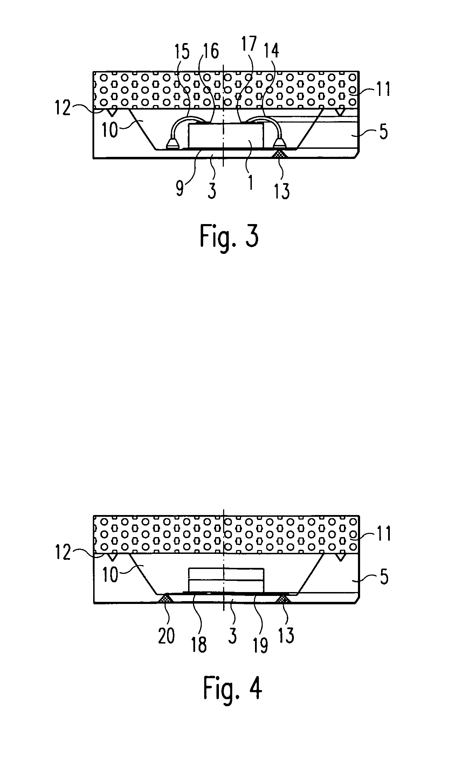

Fig. 3 shows a face up (FU) LED chip 1 which is placed on the thin membrane 3 and mechanically connected to the membrane 3 by soldering 9.

The two electrodes 16, 17 at the top of the LED chip 1 is electrically connected e.g. via gold (AU) wire bonding 14, 15.

After having placed the LED chip 1, the cavity 8 is filled, e.g. with a clear sealing silicone 10.

Preferably on top of the submount 2 with filled cavity 8 a colour conversion material 11 can be placed overlapping also the regions of the submount 2 outside the cavity 8, i.e. the top surface 12 of the supporting frame 5.

The bond wire 14 of at least one electrode 17 can be led to the outside through a filled through hole 13 in the membrane 3, the filling being e.g. made from gold or a combination of metals.

Fig. 4 shows an example for a LED chip 1 which is mount according to the flip chip (FC) technology. Again, the cavity 8 can be filled with clear silicone 10 and a colour conversion material 14 can be placed on top of the filled cavity 8 and the top surface 12 of the surrounding support frame 5.

The cathode and the anode of the LED chip 1 are facing the membrane 3.

There is a separate solder patch 18 for the cathode and a solder patch 19 for the anode, which solder patches are respectively provided on the membrane 3. AuSn can be used as solder material. The composition of the AuSn solder is ideally 80:20 wt\o and preferably formed with excess deposited gold.

In the membrane 3, there is respectively a gold-filled through hole 20 for the cathode and a through hole 13 for the anode.

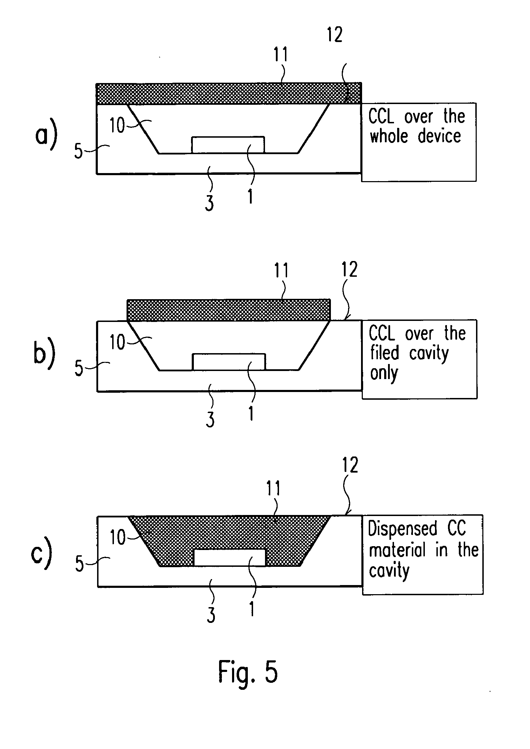

With reference to Fig. 5 now different arrangements for the colour conversion material will be explained.

In Fig. 5a schematically the arrangement as shown in Fig. 3 and 4 is illustrated. According to this embodiment a colour conversion layer 11 is covering both the cavity 8 (which can filled or "empty") and the surrounding top surface 12 of the support frame 5.

According to Fig. 5b the cavity 8 is, again, optionally filled with a clear silicone material 10, while according to this embodiment, the colour conversion layer 11 covers the top face of the cavity 8 only, but not the top surface 12 of the support frame 5.

According to Fig. 5c, the embodiment has colour conversion material 11 directly filling the cavity 8 such that the top surface of the colour conversion material flushes with the top surface 12 of the surrounding support frame 5.

According to present invention, the thin membrane for example from silicon material is always supported, i.e. throughout the entire manufacturing process, by the surrounding support frame which is made from the same material, but of greater thickness. This design can be manufactured by using a SOI technology (silicon-on-insulator technology) combined with silicon micromachining (MEMS) in order to produce a precisely defined thin membrane with low thermal resistance and the integral mechanical support around the membrane.

The invention proposes to use a silicon direct bonding process using the fact that two flat, highly polished, clean surfaces will bond together if they are brought into intimate contact. The initial bonding can be done at room temperature with some force applied to initiate the bond. The bond is formed by Van der Waal's forces, and the bond strength can be significantly improved by thermal treatment.

This process can be exploited for MEMS fabrication, for example using direct bonding with either plain or oxidised silicon wafers. The technique is often referred to as silicon fusion bonding.

Additionally, the cavity walls can be coated with a suitable reflecting material, such as for example aluminium and/or silver.

According to the invention, an excellent thermal performance of the package of less than 5 K/W across the thin membrane can be achieved.

Preferably, the thermal properties of the membrane material are similar to the properties of the LED sapphire substrate or other bonded supporting material. This prevents undesirable thermal stresses and the package during the temperature range which can be expected during the operation of the LED package.

The design of the solder path as shown in Fig. 3 and 4 is such that the area under the package is maximised to effectively spread the heat transfer over a broad surface. In particular, the electrode area is designed to correspond directly with the contour of the LED chip so no lateral spreading of the heat is necessary.

Regarding the electrical connection to the solder path, the native oxide on the silicon can be used as an electrical isolator to separate the anode and cathode of the LED chip. As shown in Fig. 3 and 4, the electrical connections can be realised through the thin membrane or on the surface of the package to the upper surface.

## Claims

1. A LED package, comprising;
- a LED chip (1) having an optically active layer on a substrate (7),
- a submount (2), on a central recessed membrane (3) of which the LED chip (1) is mounted in close thermal contact to the material of the submount (2),
the thickness of the membrane (3) being less than 100 µm, preferably less than 80µm and the thickness of a frame of the submount (2) which is integrally formed with the membrane (3), is substantially larger than the thickness of the membrane (3).

2. The LED package according to claim 1,
wherein the LED chip (1) substrate (7) has a thickness of at least in the range of 100µm.

3. The LED package according to any of the preceding claims,
wherein the LED chip (1) substrate (7) is made from sapphire.

4. The LED package according to any of the preceding claims,
wherein the submount (2) is made from sapphire or silicon.

5. The LED package according to any of the preceding claims,
wherein the walls (4) surrounding the membrane (3) form a cavity (8), wherein the walls (4) are designed as a reflector for light emitted from the LED chip (1).

6. The LED package according to claim 5,
wherein the walls (4) of the cavity (8) are coated with a reflecting material.

7. The LED package according to any of the preceding claims,
wherein the thermal resistance of the membrane (3) of the submount (2) is less than 5K/W.

8. The LED package according to any of the preceding claims,
wherein the frame of the submount (2) has a thickness of at least 300µm, preferably more than 400µm.

9. The LED package according to any of the preceding claims,
wherein the recessed membrane (3) is obtainable by an etch process into a SOI bonded wafer.

10. The LED package according to any of the preceding claims,
wherein the cavity (8) defined by the recessed membrane (3) is at least partially filled with a colour conversion material.

11. The LED package according to any of the preceding claims,
wherein the membrane (3) is provided with at least a through hole filled with electrically conducting material and connected to one of the electrodes of the LED chip (1).

12. The LED package according to any of the preceding claims,
wherein the LED chip (1) is mount in flip chip technology and wherein the membrane (3) is provided with two through holes respectively filled with electrically conducting material and connected to one of the electrodes of the LED chip (1).

13. A method for manufacturing a LED package,
comprising the steps of:
- preparing a submount (2) having a membrane (3) with a thickness of some 100µm or less and a frame integrally formed with the membrane (3) and having a thickness which is substantially larger than the thickness of the membrane (3),
wherein during the preparation the membrane (3) is always supported by the frame, and
- mounting a LED chip (1) on the membrane (3).

14. The method according to claim 13,
wherein the step of mounting the LED chip (1) comprises the step of selecting a LED chip (1) having a substrate (7) with a thickness such that the substrate (7) of the LED chip (1), together with the frame of the submount (2), procures sufficient mechanical properties to the LED package.

15. The method according to claim 13 or 14,
comprising the step of selecting the materials of the LED chip (1) substrate (7) and the submount (2), respectively, such that they have essentially comparable thermal characteristics.

16. The method according to any of claims 13 to 15,
wherein the thermal resistance of the membrane (3) of the submount (2) is some 5K/W or less.

## Amended claims

### Amended claims in accordance with Rule 86(2) EPC.

**1.** A LED package, comprising;
- a LED chip (1) having an optically active layer on a substrate (7),
- a submount (2), on a central recessed membrane (3) of which the LED chip (1) is mounted in close thermal contact to the material of the submount (2), the thickness of the membrane (3) being less than 100 µm, preferably less than 80 µm and the thickness of a frame of the submount (2) which is integrally formed with the membrane (3), is substantially larger than the thickness of the membrane (3),
wherein the submount (2) is made from sapphire or silicon.

**2.** A LED package, comprising;
- a LED chip (1) having an optically active layer on a substrate (7),
- a submount (2), on a central recessed membrane (3) of which the LED chip (1) is mounted in close thermal contact to the material of the submount (2), the thickness of the membrane (3) being less than 100 *µ*m, preferably less than 80*µ*m and the thickness of a frame of the submount (2) which is integrally formed with the membrane (3), is substantially larger than the thickness of the membrane (3),
wherein the membrane (3) is provided with at least one through hole filled with electrically conducting material and connected to one of the electrodes of the LED chip (1).

**3.** The LED package according to claim 2,
wherein the submount (2) is made from sapphire or silicon.

**4.** The LED package according to any of the preceding claims,
wherein the LED chip (1) substrate (7) has a thickness of at least in the range of 100µm.

**5.** The LED package according to any of the preceding claims,
wherein the LED chip (1) substrate (7) is made from sapphire.

**6.** The LED package according to any of the preceding claims,
wherein the walls (4) surrounding the membrane (3) form a cavity (8), wherein the walls (4) are designed as a reflector for light emitted from the LED chip (1).

**7.** The LED package according to claim 6,
wherein the walls (4) of the cavity (8) are coated with a reflecting material.

**8.** The LED package according to any of the preceding claims,
wherein the thermal resistance of the membrane (3) of the submount (2) is less than 5K/W.

**9.** The LED package according to any of the preceding claims,
wherein the frame of the submount (2) has a thickness of at least 300µm, preferably more than 400µm.

**10.** The LED package according to any of the preceding claims,
wherein the recessed membrane (3) is obtainable by an etch process into a SOI bonded wafer.

**11.** The LED package according to any of the preceding claims,
wherein the cavity (8) defined by the recessed membrane (3) is at least partially filled with a colour conversion material.

**12.** The LED package according to claim 1,
wherein the membrane (3) is provided with at least a through hole filled with electrically conducting material and connected to one of the electrodes of the LED chip (1).

**13.** The LED package according to any of the preceding claims,
wherein the LED chip (1) is mount in flip chip technology and wherein the membrane (3) is provided with two through holes respectively filled with electrically conducting material and connected to one of the electrodes of the LED chip (1).

**14.** A method for manufacturing a LED package, comprising the steps of:
- preparing a submount (2) having a membrane (3) with a thickness of some 100*µ*m or less and a frame integrally formed with the membrane (3) and having a thickness which is substantially larger than the thickness of the membrane (3),
wherein during the preparation the membrane (3) is always supported by the frame, and
- mounting a LED chip (1) on the membrane (3),
wherein the submount (2) is made from sapphire or silicon.

**15.** The method according to claim 14,
wherein the step of mounting the LED chip (1) comprises the step of selecting a LED chip (1) having a substrate (7) with a thickness such that the substrate (7) of the LED chip (1), together with the frame of the submount (2), procures sufficient mechanical properties to the LED package.

**16.** The method according to claim 14 or 15,
comprising the step of selecting the materials of the LED chip (1) substrate (7) and the submount (2), respectively, such that they have essentially comparable thermal characteristics.

**17.** The method according to any of claims 14 to 16,
wherein the thermal resistance of the membrane (3) of the submount (2) is some 5K/W or less.

**18.** A method for manufacturing a LED package, comprising the steps of:
- preparing a submount (2) having a membrane (3) with a thickness of some 100µm or less and a frame integrally formed with the membrane (3) and having a thickness which is substantially larger than the thickness of the membrane (3),
wherein during the preparation the membrane (3) is always supported by the frame, and
- producing in the membrane (3) at least one through hole filled with electrically conducting material and connected to one of the electrodes of the LED chip (1).
